# EUROPÄISCHE PATENTSCHRIFT

(11) **EP 0 307 675 B1**
(45) Veröffentlichungstag und Bekanntmachung des Hinweises auf die Patenterteilung: **03.11.1993**
(21) Anmeldenummer: 88113829.1
(22) Anmeldetag: 25.08.1988
(51) Int. Cl.: C23C 14/32, C23C 14/16

(54) **Verfahren zur Herstellung von Schichten mit hochharten und/oder reibarmen Eigenschaften**
Process for the production of layers with high hardness and/or low friction properties
Procédé de fabrication de couches ayant une grande dureté et/ou un coefficient de friction bas

(30) Priorität: 26.08.1987 DE 3728420
(43) Veröffentlichungstag der Anmeldung: 22.03.1989
(73) Patentinhaber: Repenning, Detlev, Dr., D-21465 Reinbek (DE)
(72) Erfinder: Repenning, Detlev, Dr., D-21465 Reinbek (DE)
(74) Vertreter: Schöning, Hans-Werner, Dipl.-Ing.

(56) Entgegenhaltungen:
- WO-A-87/02072
- GB-A- 2 058 843
- US-A- 4 540 596
- JOURNAL OF VACUUM SCIENCE & TECHNOLOGY, Band 3, Nr. 3, Part 1, Mai-Juni 1985, Seiten 553-560, American Vaccum Society, Woodbury, New York, US; R.F. BUNSHAH et al.: "Plasma assisted physical vapor deposition processes: A review"
- THIN SOLID FILMS, Band 107, Nr. 1, September 1983, Seiten 21-38, Elsevier Sequoia, Lausanne, CH; R.F. BUNSHAH: "Processes of the activated reactive evaporation type and their tribological applications"
- H.Pulker et al.: "Verschleissschutzschichten unter Anwendung der CVD/PVD-Verfahren", Kontakt & Studium Band 188, Expert Verlag, Sindelfingen (1985), Seiten 179-181

## Beschreibung

Die Erfindung betrifft ein Verfahren zur Herstellung von Schichten mit hochharten und/oder reibarmen Eigenschaften, bei dem in einem Vakuum, in das ein reaktives Gas eingeführt wird, sich auf einem elektrischen Potential befindendes Targetmaterial in ein Targetplasma überführt wird, das auf ein Substrat, das auf einem höheren elektrischen Potential als das Targetmaterial liegt, zur Bildung der Schicht gelangt, wobei das Targetmaterial aus Metall gebildet wird und das Metall mittels eines Lichtbogens zu einem Metallplasma verdampft wird und das gemeinsam mit dem reaktiven Gas zur Bildung der Schicht beiträgt.

Ein Verfahren dieser Art ist bekannt (WO-A-8 702 072). Das bekannte Verfahren basiert auf der Anwendung eines seit langem bekannten PVD-Verfahrens (Physical Vapour Deposition), das durch bestimmte Verfahrensschritte gegenüber den bis dahin bekannten PVD-Verfahren modifiziert ist. Dort wird eine Metallzerstäubungstechnik mittels eines Lichtbogens beschrieben, der die bis dahin übliche Metallzerstäubungstechnik ersetzt. Mit dem bekannten Verfahren werden Schichtungen erzeugt, die festkörperphysikalisch sogenannte 1-phasige Schichten darstellen, wobei es sich um interstitiell gelösten Kohlenstoff im Metall handelt, d.h. der Kohlenstoff bildet mit dem Metall eine feste Lösung. Interstitielle Lösungen bilden homogene feste Mischungen, in denen zwei oder mehrere chemische Stoffe ein gemeinsames Kristallgitter bilden.

Die Herstellung derartiger Schichten, insbesondere kohlenstoffreicher Carbid-Composite-Verbindungen, erfolgt heutzutage unter Anwendung der bekannten PVD-Verfahren (Magnetronsputtern). Dabei wird in einem Hochvakuumrezipienten Metall mittels Argon-Ionenbeschuß zerstäubt. Durch Hinzufügen eines kohlenstoffhaltigen Gases, beispielsweise Azetylen, reagiert das Metall an der Oberfläche eines auf negativem Potential liegenden Substrats, das ein zu beschichtendes Werkstück sein kann, zu einem Metallcarbid oder bei entsprechend hohem Druck des Azetylens zu sogenanntem Metallkohlenstoff.

Um jedoch Schichten der eingangs genannten Art in unbegrenzter Zahl reproduzieren zu können, d. h. mit Eigenschaften, die fortwährend bei allen zu beschichtenden Werkstücken oder dergl. gleich sind, ist es nötig, daß der Kohlenwasserstoff im Plasma hochionisiert ist.

Der Nachteil der bekannten PVD-Verfahren sowie des oben genannten bekannten PVD-Verfahrens liegt darin, daß bei allen bekannten PVD-Metallzerstäubungstechniken der Ladungsanteil der zerstäubten Metallteilchen nur bei ca. 1-5 % liegt.

Es ist Aufgabe der vorliegenden Erfindung, ein Verfahren zu schaffen, mit dem im Vergleich zu den bekannten Verfahren Schichten hergestellt werden können, die fortwährend gleiche Eigenschaften haben und die gegenüber den mit den bekannten Verfahren hergestellten Schichten bessere physikalische und chemische Eigenschaften haben, wobei das Verfahren gegenüber dem bekannten Verfahren mit einfacheren Mitteln ausführbar sein soll.

Gelöst wird die Aufgabe gemäß der Erfindung dadurch, daß die Überführung des Metalls in das Plasma in der Gasphase ionisierten Kohlenstoffs, der infolge eines Glimmentladungsvorganges eines kohlenstoffhaltigen Gases an einer auf einem höherem Potential als das Targetmaterial befindlichen Elektrode der Elektrodenanordnung ionisiert wird, zur Bildung einer mikro- oder nanodispersen zweiphasigen Metallcarbid-Kohlenstoffschicht (Schicht aus einem Gemisch von Metallcarbid und elementarem Kohlenstoff) erfolgt, wobei das Metall in der Gasphase bis in den Bereich von 90 % ionisiert wird.

Der Vorteil des erfindungsgemäßen Verfahrens besteht im wesentlichen darin, daß im Bereich der Substratelektrode infolge eines geeignet dort gewählten Potentials zwischen den Elektroden ein Glimmentladungsvorgang stattfindet, durch den gasförmiger Kohlenstoff derart ionisiert wird, daß die durch den Lichtbogen erzeugten Metallionen des Metallplasmas mit den erzeugten Kohlenstoffionen kollidieren mit der Folge, daß die Kohlenstoffionen energetisch hoch angeregt werden, so daß der Kohlenstoff Strukturen einnimmt, die hochhart sind. Ein weiterer Vorteil ist, daß darüber hinaus durch den hohen Ionisierungsanteil des im Lichtbogen verdampften Metalls besonders günstige Voraussetzungen zum Wachstum von leitfähigen Metallcarbid-Kohlenstoffschichten geschaffen werden. Gemäß einer vorteilhaften Ausgestaltung der Erfindung wird der Kohlenstoff infolge eines Glimmentladungsvorganges an einer auf einem höheren Potential als das Targetmaterial befindlichen Elektrodenanordnung ionisiert. Denkbar ist es, daß der ionisierte Kohlenstoff auch an anderer Stelle erzeugt und in das Vakuum eingebracht wird, vorteilhafterweise wird jedoch durch die Ionisierung des Kohlenstoffs durch Glimmentladung im Vakuum der Ionisierungsgrad auf einfache Weise geregelt, so daß das Verfahren insgesamt gemäß dieser Ausgestaltung einfacher durchgeführt werden kann.

Zur Erzeugung des ionisierten Kohlenstoffs werden gemäß einer weiteren vorteilhaften Ausgestaltung der Erfindung Kohlenwasserstoffe wie Methan, Propan, Azetylen oder Butadien verwendet. Grundsätzlich eignen sich dazu aber auch andere, hier nicht gesondert aufgeführte Kohlenwasserstoffgase.

Um die Ausbildung von Mikrotropfen in der Schicht zu verhindern, was insbesondere bei hohen Gasdichten geschehen kann, wird vorzugsweise in das Vakuum bzw. zum Kohlenstoff ein nicht-reaktives Gas gegeben. Dieses Gas kann vorteilhafterweise Argon sein.

Gemäß einer weiteren vorteilhaften Ausführungsform der Erfindung weist das Kohlenwasserstoffgas bei der Ausführung des Verfahrens einen Druck von 10⁻⁵ bis 10⁻¹ mbar auf. Es sei aber darauf verwiesen, daß der Druck des Kohlenwasserstoffgases für bestimmte auszubildende Schichten mit bestimmten zu erwartenden Eigenschaften auf bestimmte Werte optimiert werden kann.

Als Targetmaterial erweisen sich vorzugsweise alle refraktären Metalle als geeignet, wobei diese Metalle vorteilhafterweise Titan, Zirkon, Hafnium, Vanadium, Molybdän oder auch beliebige andere sein können.

Die das Targetmaterial bildenden Metalle können aber auch, je nach der Art der zu auszubildenden Schicht, vorzugsweise Eisenmetalle sein, wobei als Eisenmetalle vorteilhafterweise Nickel, Eisen oder Kobalt verwendet werden.

Es kann für bestimmte auszubildende Schichten vorteilhaft sein, daß die das Targetmaterial bildenden Metalle die Legierungen der Eisenmetalle sind.

Schließlich ist gemäß einer weiteren Ausgestaltung des Verfahrens durch vorbestimmte Variation der Substratspannung der Kohlenstoffgehalt der Schicht einstellbar.

Es sei hervorgehoben, daß gemäß dem hier vorgeschlagenen Verfahren auch Mehrfachschichten hergestellt werden können, wobei die einzelnen Schichten aus unterschiedlichen Metallen bzw. Metallegierungen aufgebaut sind.

Das Verfahren kann grundsätzlich in einem gewöhnlichen Rezipienten durchgeführt werden, in dem über eine Pumpeneinrichtung ein Vakuum erzeugt wird. Über einen Gaseinlaß kann ein beliebiges Kohlenwasserstoffgas, beispielsweise Methan, Propan, Azetylen oder Butadien eingelassen werden.

Ein Target aus einem metallischen Targetmaterial, das aus refraktären Metallen wie Titan, Zirkon, Hafnium, Vanadium, Molybdän oder Wolfram ausgebildet sein kann, ist mit einer geeigneten Spannungsquelle verbunden. Ebenso ist eine Substratelektrode, die beispielsweise das zu beschichtende Werkstück bildet, mit einer Spannungsquelle verbunden. Das elektrische Potential des Substrats (zu beschichtendes Werkstück) ist negativer (höher) als das Potential des Targetmaterials. Von einer Lichtbogenquelle wird ein Lichtbogen auf das Targetmaterial gegeben. Infolge der Ausbildung des Lichtbogens wird das Metall des Targets "verdampft", so daß das Metall als Metallplasma in die Gasphase überführt wird. Die Folge ist, daß das "verdampfte" Metall dann zu wenigstens 90 % in der Gasphase elektrisch geladen, d. h. ionisiert ist.

Im Bereich der Substratelektrode findet infolge des negativen Potentials relativ zu den Rezipientenwänden zwischen beiden Elektroden ein Glimmentladungsvorgang statt, durch den das Kohlenwasserstoffgas, mag es das Methan, Propan, Azetylen, Butadien oder auch ein anderes Kohlenwasserstoffgas sein, ionisiert wird. Die durch den Lichtbogen erzeugten Metallionen des Metallplasmas kollidieren mit den Kohlenstoffionen mit der Folge, daß die Kohlenstoffionen energetisch hoch angeregt werden, so daß der Kohlenstoff beispielsweise Strukturen einnimmt, die hochhart sind.

Die durch den Lichtbogen "verdampften" Metallionen driften in Richtung Substrat (Werkstück) und reagieren an der Oberfläche mit dem Kohlenstoff des Kohlenwasserstoffs zu mikrodispersen 2-Phasen-Schichten, die aus Carbiden und elementarem Kohlenstoff (mikroskopisch disperses Gemisch) bestehen. Die entstehenden Schichten sind sehr hart und reibarm.

Es sei hervorgehoben, daß der Prozeß gemäß diesem Verfahren in einem Hochvacuum-Rezipienten vorteilhafterweise in einem Druckbereich des Kohlenwasserstoffgases zwischen 10⁻⁵ bis 10⁻¹ mbar abläuft. Das Kohlenwasserstoffgas kann dabei durch nicht-reaktive Gase, beispielsweise durch Argon verdünnt sein. Die Zugabe eines nicht-reaktiven Gases verhindert bei hohen Gasdrucken von beispielsweise 2 · 10⁻² mbar die Ausbildung von Mikrotropfen in der Schicht. Der Druck des nicht-reaktiven Gases beträgt dabei vorzugsweise z.B. 4 · 10⁻³ mbar.

Gemäß dem Verfahren sind Schichten aufbaubar, die infolge der Zunahme bzw. Abnahme der steuerbaren Lichtbogenintensität unterschiedliche Eigenschaften haben. So können beispielsweise harte Metallkarbidschichten bis hin zu reibarmen Metallkohlenstoffschichten mit beispielsweise einem Metallgehalt von nur noch 5 bis 10 % erzeugt werden, d. h. Schichten, die zwischen sehr reibarmen und sehr harten Eigenschaften liegen. Durch vorbestimmte Variation der Substratspannung ist weiterhin der Kohlenstoffgehalt der Schicht einstellbar, der beispielsweise bei einer Spannung von -50 V relativ zu den Wänden des Rezipienten deutlich erhöht werden kann.

Auch ist es gemäß dem Verfahren möglich, daß auf das gleiche Substrat Schichten unterschiedlicher vorbestimmter physikalischer Eigenschaften im vorangehend beschriebenen Sinne aufeinander aufgebracht werden.

## Patentansprüche

1. Verfahren zur Herstellung von Schichten mit hochharten und/oder reibarmen Eigenschaften, bei dem in einem Vakuum, in das ein reaktives Gas eingeführt wird, sich auf einem elektrischen Potential befindendes Targetmaterial in ein Targetplasma überführt wird, das auf ein Substrat, das auf einem höheren elektrischen Potential als das Targetmaterial liegt, zur Bildung der Schicht gelangt, wobei das Targetmaterial aus Metall gebildet wird und das Metall mittels eines Lichtbogens zu einem Metallplasma verdampft wird und das gemeinsam mit dem reaktiven Gas zur Bildung der Schicht beiträgt, dadurch gekennzeichnet, daß die Überführung des Metalls in das Plasma in der Gasphase ionisierten Kohlenstoffs, der infolge eines Glimmentladungsvorganges eines kohlenstoffhaltigen Gases an einer auf einem höherem Potential als das Targetmaterial befindlichen Elektrode der Elektrodenanordnung ionisiert wird, zur Bildung einer mikro- oder nanodispersen zweiphasigen Metallcarbid-Kohlenstoffschicht (Schicht aus einem Gemisch von Metallcarbid und elementarem Kohlenstoff) erfolgt, wobei das Metall in der Gasphase bis in den Bereich von 90 % ionisiert wird.

2. Verfahren nach Anspruch 1, dadurch gekennzeichnet, daß zur Erzeugung des ionisierten Kohlenstoffs Kohlenwasserstoffe wie Methan, Propan, Azetylen oder Butadien verwendet werden.

3. Verfahren nach einem oder beiden der Ansprüche 1 oder 2, dadurch gekennzeichnet, daß das Kohlenwasserstoffgas bei der Ausführung des Verfahrens einen Druck von 10⁻⁵ bis 10⁻¹ mbar aufweist.

4. Verfahren nach einem oder mehreren der Ansprüche 1 bis 3, dadurch gekennzeichnet, daß in das Vakuum ein nicht-reaktives Gas gegeben wird.

5. Verfahren nach Anspruch 4, dadurch gekennzeichnet, daß das nicht-reaktive Gas Argon ist.

6. Verfahren nach einem oder mehreren der Ansprüche 1 bis 5, dadurch gekennzeichnet, daß die das Targetmaterial bildenden Metalle refraktäre Metalle sind.

7. Verfahren nach Anspruch 6, dadurch gekennzeichnet, daß die refraktären Metalle Titan, Zirkon, Hafnium, Vanadium, Molybdän oder Wolfram sind.

8. Verfahren nach einem oder mehreren der Ansprüche 1 bis 5, dadurch gekennzeichnet, daß die das Targetmaterial bildenden Metalle Eisenmetalle sind.

9. Verfahren nach Anspruch 8, dadurch gekennzeichnet, daß die Eisenmetalle Eisen, Nickel oder Kobalt sind.

10. Verfahren nach einem oder beiden der Ansprüche 8 oder 9, dadurch gekennzeichnet, daß die das Targetmaterial bildenden Metalle die Legierungen der Eisenmetalle sind.

11. Verfahren nach einem oder mehreren der Ansprüche 1 bis 10, dadurch gekennzeichnet, daß durch vorbestimmte Variation der Substratspannung der Kohlenstoffgehalt in der Schicht einstellbar ist.

## Claims

1. A method of producing layers of high hardness and/or low friction properties in which in a vacuum into which a reactive gas is introduced, target material which is at an electrical potential is converted to a target plasma which is applied to a substrate which is at a higher electrical potential than the target material, in order to form the layer, the target material consisting of metal while the metal is vaporised by an arc to produce a metal plasma and contributing jointly with the reactive gas to the formation of the layer, characterised in that the conversion of the metal into the plasma takes place in the gaseous phase of ionised carbon which, due to a glow discharge process of a carbonaceous gas, is ionised on an electrode of the electrode arrangement which is at a higher potential than the target material, in order to form a micro or nano-disperse two-phase metal carbide carbon layer (layer of a mixture of metal carbide and elementary carbon), the metal in the gaseous phase being ionised into the range of 90%.

2. A method according to claim 1, characterised in that hydrocarbons such as methane, propane, acetylene or butadiene are used for producing the ionised carbon.

3. A method according to one or both of claims 1 or 2, characterised in that the hydrocarbon gas is at a pressure of 10⁻⁵ to 10⁻¹ mbar while the method is being performed.

4. A method according to one or more of claims 2 to 3, characterised in that a non-reactive gas is added to the vacuum.

5. A method according to claim 4, characterised in that the non-reactive gas is argon.

6. A method according to one or a plurality of claims 1 to 5, characterised in that the metals forming the target material are refractory metals.

7. A method according to claim 6, characterised in that the refractory metals are titanium, zirconium, hafnium, vanadium, molybdenum or tungsten.

8. A method according to one or more of claims 1 to 5, characterised in that the metals forming the target material are ferrous metals.

9. A method according to claim 8, characterised in that the ferrous metals are iron, nickel or cobalt.

10. A method according to one or both of claims 8 or 9, characterised in that the metals forming the target material are the alloys of the ferrous metals.

11. A method according to one or a plurality of claims 1 to 10, characterised in that the carbon content in the layer can be adjusted by a predetermined fluctuation of the substrate voltage.

## Revendications

1. Procédé pour fabriquer des couches possédant des caractéristiques de grande dureté/ou de faible coefficient de frottement, selon lequel dans un espace vide, dans lequel est introduit un gaz réactif, un matériau cible placé à un potentiel électrique est converti en un plasma du matériau cible qui atteint un substrat, qui est placé à un potentiel électrique supérieur à celui du matériau cible, pour la formation de la couche, selon lequel le matériau cible est formé d'un métal, et le métal est vaporisé au moyen d'un arc électrique pour former un plasma du métal, le gaz réactif contribuant avec le plasma, à former la couche, caractérisé en ce que la conversion du métal en le plasma s'effectue dans la phase gazeuse de carbone ionisé, qui est ionisé en raison d'un processus de décharge à effluves d'un gaz contenant du carbone sur une électrode du dispositif d'électrodes, qui est placée à un potentiel supérieur à celui du matériau cible, pour la formation d'une couche biphasée carbure métallique-carbone dispersée à une taille de l'ordre du micron ou du nanomètre (couche formée d'un mélange de carbure métallique et de carbone élémentaire), le métal étant ionisé dans la phase gazeuse jusqu'à un pourcentage de 90%.

2. Procédé selon la revendication 1, caractérisé en ce que pour l'obtention du carbone ionisé, on utilise des hydrocarbures tels que du méthane, du propane, de l'acétylène ou du butadiène.

3. Procédé selon l'une des revendications 1 ou 2 ou ces deux revendications, caractérisé en ce que le gaz d'hydrocarbure possède, pour la mise en oeuvre du procédé, une pression comprise entre 10⁻⁵ et 10⁻¹ mbars.

4. Procédé selon l'une ou plusieurs des revendications 1 à 3, caractérisé en ce qu'un gaz non réactif est introduit dans l'espace vide.

5. Procédé selon la revendication 4, caractérisé en ce que le gaz non réactif est de l'argon.

6. Procédé selon l'une ou plusieurs des revendications 1 à 5, caractérisé en ce que les métaux constituant le matériau cible sont des métaux réfractaires.

7. Procédé selon la revendication 6, caractérisé en ce que les métaux réfractaires sont le titane, le zircon, le hafnium, le vanadium, le molybdène ou le tungstène.

8. Procédé selon l'une ou plusieurs des revendications 1 à 5, caractérisé en ce que les métaux constituant le matériau cible sont des métaux ferreux.

9. Procédé selon la revendication 8, caractérisé en ce que les métaux ferreux sont le fer, le nickel ou le cobalt.

10. Procédé selon l'une des revendications 8 ou 9 ou selon ces deux revendications, caractérisé en ce que les métaux constituant le matériau cible sont les alliages des métaux ferreux.

11. Procédé selon l'une ou plusieurs des revendications 1 à 10, caractérisé en ce que la teneur en carbone dans la couche est réglable grâce à une modification prédéterminée de la tension du substrat.
